# EUROPEAN PATENT APPLICATION

(11) **EP 3 968 128 A1**
(43) Date of publication of application: **16.03.2022**
(21) Application number: 20290063.5
(22) Date of filing: 15.09.2020
(51) Int. Cl.: G06F 1/28, G05B 23/02, G06F 1/30, B60R 16/03

(54) **METHOD, DEVICE, AND COMPUTER PROGRAM FOR VERIFYING POWER SUPPLY MONITORING**

(71) Applicant: NXP USA, Inc., Austin TX 78735 (US)
(72) Inventor: Tico, Olivier, 31023 Toulouse Cedex 1 (FR); Desposito, Domenico, 31023 Toulouse Cedex 1 (FR); D'Esposito, Francesco, 5656 AG Eindhoven (NL)
(74) Representative: Krott, Michel

(57) **Abstract**

There is described a method of verifying a function of a power supply monitor (230) in a digital control system, wherein the power supply monitor is adapted to monitor whether or not a power supply voltage (VDDD) is between a lower threshold value (V_{LT}) and an upper threshold value (V_{UT}). The method comprises: setting (310) the power supply voltage to a first value (V₁), the first value being below the lower threshold value, checking (320), as a first check, that the power supply monitor indicates that the power supply voltage is below the lower threshold value, setting (330) the power supply voltage to a second value (V₂), the second value being above the lower threshold value and below the upper threshold value, checking (340), as a second check, that the power supply monitor indicates that the power supply voltage is above the lower threshold value, and verifying (350) the function of the power supply monitor if both the first check and the second check are successful. There is also described a corresponding device and computer program.

## Description

### FIELD OF THE INVENTION

The present invention relates to the field of safety in electronic control systems, in particular for vehicles with combustion engine, electrical engine or both (hybrid vehicles). More specifically, the present invention relates to methods, devices and computer programs for verifying a function of a power supply monitor in a digital control system, wherein the power supply monitor is adapted to monitor whether or not a power supply voltage is in a desired range between a lower threshold value and an upper threshold value.

### ART BACKGROUND

In order to get ASIL D (Automotive Safety Integrity Level D) ranking, which is the highest level of safety in automotive applications), for functional safety integrated circuits, all common cause failures must be monitored. Power supplies are one of the usual common cause failures, including a digital power supply block. Since the digital power supply block operates properly only between a minimum voltage and a maximum voltage, and it must manage all operations (such as wake-up, power supply management, data processing, etc...), its supply monitoring is safety related. Hence, the power supply monitoring needs to be verified from time to time in order to detect a malfunction and react by moving the Integrated Circuit (IC) into a safe state (e.g. performing a reset).

Detection of a malfunction in the power supply monitoring can be avoided by utilizing monitoring redundancy, i.e. by having two or more redundant monitoring units. However, such redundancy costs die size and current consumption.

There may thus be a need for a simple and reliably way of verifying the power supply monitoring without the drawbacks caused by monitor redundancy.

### SUMMARY OF THE INVENTION

This need may be met by the subject matter according to the independent claims. Advantageous embodiments of the present invention are set forth in the dependent claims.

According to a first aspect, there is provided a method of verifying a function of a power supply monitor in a digital control system, wherein the power supply monitor is adapted to monitor whether or not a power supply voltage is between a lower threshold value and an upper threshold value (i.e. within an operating range delimited by the lower and upper threshold values). The digital control system may in particular be a digital vehicle control system. The method comprises (a) setting the power supply voltage to a first value, the first value being below the lower threshold value, (b) checking, as a first check, that the power supply monitor indicates that the power supply voltage is below the lower threshold value, (c) setting the power supply voltage to a second value, the second value being above the lower threshold value and below the upper threshold value, (d) checking, as a second check, that the power supply monitor indicates that the power supply voltage is above the lower threshold value, and (e) verifying the function of the power supply monitor if both the first check and the second check are successful.

This aspect is based on the idea that the power supply is controlled to first provide a voltage (first value) below the lower threshold value and then, after checking that the output from the power supply monitor indicates a low supply voltage, to provide a voltage (second value) above the lower threshold value. If this increase (from the first value to the second value) in the power supply voltage causes the output from the power supply monitor to switch accordingly (i.e. from indicating a low voltage to indicating a proper voltage), then the ability of the power supply monitor to detect whether the supply voltage is below or above the lower threshold value has been verified.

This simple verification process may be performed on a regular basis, e.g. when starting and stopping a vehicle (at the beginning or end of a ride) or even during use, e.g. when stopping the vehicle at a red light. Furthermore, the verification process may also be performed before or during a battery charging operation.

The method according to this aspect provides a simple and reliably way of verifying the function of the power supply monitor, in particular with regard to the lower threshold value, without utilizing redundancy.

According to an embodiment, the method further comprises resetting the digital control system and/or issuing an error message if at least one of the first check and the second check is not successful. In the case of an error message, this will usually be issued by a main control system upon becoming aware of the failed verification.

If one or both of the first and second checks is/arc not successful, the power supply monitor does not function properly. In this case, at least one of the actions of resetting the digital control system and issuing an error message is performed. By resetting the control system, the vehicle is put in a safe state or operational mode or it may even be prevented from starting. An error message is useful for the vehicle owner in order to take appropriate action to get the vehicle back in a fully functional state.

According to a further embodiment, the first value is larger than a minimum safe operating voltage of the digital control system.

In other words, the first value is below the lower threshold value but above the minimum safe operating voltage. Thus, although the first value is outside of the operating voltage range defined by the lower and upper threshold values, the control system will be able to operate when the supply voltage is set to the first value.

The second value is preferably within the operating range defined by the lower and upper threshold values.

According to a further embodiment, the first value is 1.9 V and/or the second value is 2.5 V.

According to a further embodiment, the lower threshold value is 2.0 V and/or the upper threshold value is 2.6 V.

According to a further embodiment, the method further comprises (a) setting the power supply voltage to a third value, the third value being above the upper threshold value, (b) checking, as a third check, that the power supply monitor indicates that the power supply voltage is above the upper threshold value, (c) setting the power supply voltage to a fourth value, the fourth value being below the upper threshold value and above the lower threshold value, and (d) checking, as a fourth check, that the power supply monitor changes to indicate that the power supply voltage is below the upper threshold value, wherein the function of the power supply monitor is verified if, in addition to the first check and the second check, also the third check and the fourth check are successful.

In this embodiment, the ability of the power supply monitor to properly detect whether the supply voltage is below or above the upper threshold value is also verified. More specifically, the power supply is controlled to first provide a voltage (third value) above the upper threshold value and then, after checking that the output from the power supply monitor indicates a high supply voltage, to provide a voltage (fourth value) below the upper threshold value. If this decrease (from the third value to the fourth value) in the power supply voltage causes the output from the power supply monitor to switch accordingly (i.e. from indicating a high voltage to indicating a proper voltage), then the ability of the power supply monitor to detect whether the supply voltage is below or above the upper threshold value has been verified.

The method according to this embodiment is also capable of verifying the function of the power supply monitor with regard to the upper threshold value without utilizing redundancy.

According to a further embodiment, the method further comprises resetting the digital control system and/or issuing an error message if at least one of the first check, the second check, the third check, and the fourth check is not successful.

If one or more of the first to fourth checks is/are not successful, the power supply monitor does not function properly. In this case, at least one of the actions of resetting the digital control system and issuing an error message is performed. By resetting the control system, the vehicle is put in a safe state or operational mode or it may even be prevented from starting. An error message is useful for the vehicle owner in order to take appropriate action to get the vehicle back in a fully functional state.

According to a further embodiment, the third value is less than a maximum safe operating voltage of the digital control system.

In other words, the third value is above the upper threshold value but below the maximum safe operating voltage. Thus, although the third value is outside of the operating voltage range defined by the lower and upper threshold values, the control system will be able to operate when the supply voltage is set to the third value.

The fourth value is preferably within the operating range between the lower and upper threshold values. The fourth value may be equal to the second value.

According to a further embodiment, the digital control system is ASIL D (Automotive Safety Integrity Level D) compliant.

According to a further embodiment, the power supply monitor comprises (a) an undervoltage monitoring unit configured to compare the power supply voltage with the lower threshold value and to output a signal indicative of whether the power supply voltage is below or above the lower threshold value, and (b) at least one overvoltage monitoring unit configured to compare the power supply voltage with the upper threshold value and to output a signal indicative of whether the power supply voltage is below or above the upper threshold value.

In other words, the power supply monitor comprises at least two monitoring units: an undervoltage monitoring unit for monitoring voltage fluctuations around the lower threshold value, and an overvoltage monitoring unit for monitoring voltage fluctuations around the upper threshold value. Each of these units preferably outputs a binary value indicating whether the supply voltage is above or below the respective threshold value.

According to a second aspect, there is provided a device for verifying a function of a power supply monitor in a digital control system, wherein the power supply monitor is adapted to monitor whether or not a power supply voltage is between a lower threshold value and an upper threshold value (i.e. within an operating range delimited by the lower and upper threshold values). The digital control system may in particular be a digital vehicle control system. The device comprises a controller in communication with a power supply voltage regulator and the power supply monitor, wherein the controller is configured to (a) send a first control signal to the power supply voltage regulator to set the power supply voltage to a first value, the first value being below the lower threshold value, (b) check, as a first check, that a first feedback signal received from the power supply monitor indicates that the power supply voltage is below the lower threshold value, (c) send a second control signal to the power supply voltage regulator to set the power supply voltage to a second value, the second value being above the lower threshold value and below the upper threshold value, (d) check, as a second check, that a second feedback signal received from the power supply monitor indicates that the power supply voltage is above the lower threshold value, and (e) verify the function of the power supply monitor if both the first check and the second check are successful.

This aspect is essentially based on the same idea as the first aspect discussed above and provides a device capable of implementing and performing the method according to the first aspect. The device may perform the simple verification process on a regular basis, e.g. when starting and stopping a vehicle (at the beginning or end of a ride) or even during use, e.g. when stopping at a red light.

The device according to this embodiment is also capable of verifying the function of the power supply monitor, in particular with regard to the lower threshold value, without utilizing redundancy.

According to a further embodiment, the controller is further configured to reset the digital control system and/or issue an error message if at least one of the first check and the second check is not successful. In the case of an error message, this will usually be issued by a main control system upon becoming aware of the failed verification.

If one or both of the first and second checks is/are not successful, the power supply monitor does not function properly. In this case, at least one of the actions of resetting the digital control system and issuing an error message is performed. By resetting the control system, the vehicle is put in a safe state or operational mode or it may even be prevented from starting. An error message is useful for the vehicle owner in order to take appropriate action to get the vehicle back in a fully functional state.

According to a further embodiment, the first value is larger than a minimum safe operating voltage of the digital control system.

In other words, the first value is below the lower threshold value but above the minimum safe operating voltage. Thus, although the first value is outside of the operating voltage range defined by the lower and upper threshold values, the control system will be able to operate when the supply voltage is set to the first value.

According to a further embodiment, the first value is 1.9 V and/or the second value is 2.5 V, and/or the lower threshold value is 2.0 V and/or the upper threshold value is 2.6 V.

According to a further embodiment, the controller is further configured to (a) send a third control signal to the power supply voltage regulator to set the power supply voltage to a third value, the third value being above the upper threshold value, (b) check, as a third check, that a third feedback signal received from the power supply monitor indicates that the power supply voltage is above the upper threshold value, (c) send a fourth control signal to the power supply voltage regulator to set the power supply voltage to a fourth value, the fourth value being below the upper threshold value and above the lower threshold value, and (d) check, as a fourth check, that a fourth feedback signal received from the power supply monitor indicates that the power supply voltage is below the upper threshold value, wherein the function of the power supply monitor is verified if, in addition to the first check and the second check, also the third check and the fourth check are successful.

In this embodiment, the device also verifies the ability of the power supply monitor to properly detect whether the supply voltage is below or above the upper threshold value. More specifically, the power supply is controlled to first provide a voltage (third value) above the upper threshold value and then, after checking that the output from the power supply monitor indicates a high supply voltage, to provide a voltage (fourth value) below the upper threshold value. If this decrease (from the third value to the fourth value) in the power supply voltage causes the output from the power supply monitor to switch accordingly (i.e. from indicating a high voltage to indicating a proper voltage), then the ability of the power supply monitor to detect whether the supply voltage is below or above the upper threshold value has been verified.

The device according to this embodiment is also capable of verifying the function of the power supply monitor with regard to the upper threshold value without utilizing redundancy.

According to a further embodiment, the controller is further configured to reset the digital control system and/or issue an error message if at least one of the first check, the second check, the third check, and the fourth check is not successful.

If one or more of the first to fourth checks is/are not successful, the power supply monitor does not function properly. In this case, at least one of the actions of resetting the digital control system and issuing an error message is performed. By resetting the control system, the vehicle is put in a safe state or operational mode or it may even be prevented from starting. An error message is useful for the vehicle owner in order to take appropriate action to get the vehicle back in a fully functional state.

According to a further embodiment, the third value is less than a maximum safe operating voltage of the digital control system.

In other words, the third value is above the upper threshold value but below the maximum safe operating voltage. Thus, although the third value is outside of the operating voltage range defined by the lower and upper threshold values, the control system will be able to operate when the supply voltage is set to the third value.

The fourth value is preferably within the operating range, i.e. between the lower and upper threshold values. The fourth value may be equal to the second value.

According to a further embodiment, the digital control system is ASIL D (Automotive Safety Integrity Level D) compliant.

According to a further embodiment, the power supply monitor comprises (a) an undervoltage monitoring unit configured to compare the power supply voltage with the lower threshold value and to output a signal indicative of whether the power supply voltage is below or above the lower threshold value, and (b) at least one overvoltage monitoring unit configured to compare the power supply voltage with the upper threshold value and to output a signal indicative of whether the power supply voltage is below or above the upper threshold value.

In other words, the power supply monitor comprises at least two monitoring units: an undervoltage monitoring unit for monitoring voltage fluctuations around the lower threshold value, and an overvoltage monitoring unit for monitoring voltage fluctuations around the upper threshold value. Each of these units preferably outputs a binary value indicating whether the supply voltage is above or below the respective threshold value.

According to a third aspect, there is provided a computer program comprising computer executable instructions which, when executed by a computer, causes the computer to perform a method of verifying a function of a power supply monitor in a digital control system, wherein the power supply monitor is adapted to monitor whether or not a power supply voltage is between a lower threshold value and an upper threshold value. The method comprises (a) setting the power supply voltage to a first value, the first value being below the lower threshold value, (b) checking, as a first check, that the power supply monitor indicates that the power supply voltage is below the lower threshold value, (c) setting the power supply voltage to a second value, the second value being above the lower threshold value and below the upper threshold value, (d) checking, as a second check, that the power supply monitor indicates that the power supply voltage is above the lower threshold value, and (e) verifying the function of the power supply monitor if both the first check and the second check are successful.

This aspect is essentially based on the same idea as the first and second aspects described above and provides a computer program capable of implementing and performing the method according to the first aspect.

It should be noted that embodiments of the invention have been described with reference to different subject matters. In particular, some embodiments have been described with reference to method type claims whereas other embodiments have been described with reference to apparatus type claims. However, a person skilled in the art will gather from the above and the following description that, unless otherwise indicated, in addition to any combination of features belonging to one type of subject matter also any combination of features relating to different subject matters, in particular a combination of features of the method type claims and features of the apparatus type claims, is also disclosed with this document.

The aspects defined above and further aspects of the present invention will be apparent from the examples of embodiment to be described hereinafter and are explained with reference to the examples of embodiment. The invention will be described in more detail hereinafter with reference to examples of embodiment to which the invention is, however, not limited.

### BRIEF DESCRIPTION OF THE DRAWING

Figure 1 shows an illustration of a general safe operating area for a vehicle control circuit in accordance with an exemplary embodiment.
Figure 2 shows a diagram of a system comprising a device for verifying the function of a power supply monitor in accordance with an exemplary embodiment.
Figure 3 shows a flowchart of a method of verifying the function of a power supply monitor in accordance with an exemplary embodiment.
Figure 4 shows an illustration of a power supply operating area for a vehicle control circuit in accordance with an exemplary embodiment.
Figure 5 shows voltages and control signals as functions of time during a successful verification of the function of a power supply monitor in accordance with an exemplary embodiment.
Figure 6 shows voltages and control signals as functions of time during a non-successful verification of the function of a power supply monitor in accordance with an exemplary embodiment.

### DETAILED DESCRIPTION

The illustration in the drawing is schematic. It is noted that in different figures, similar or identical elements are provided with the same reference signs or with reference signs, which differ only within the first digit.

In order to get functional digital block operation, both junction temperature and digital block power supply must be within certain (minimum and maximum) limits. These limits depend on the particular technology, especially with regard to the power supply voltage.

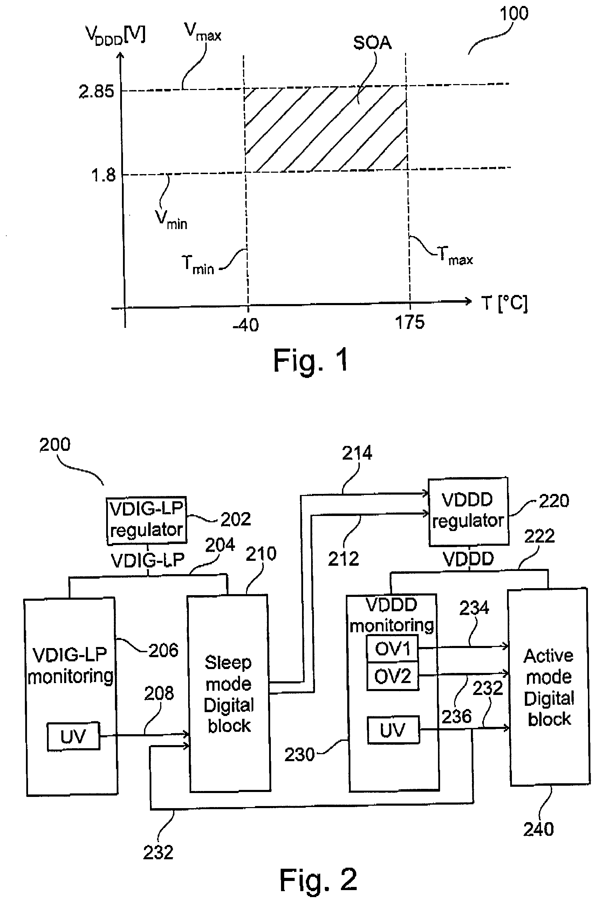

Figure 1 shows an illustration 100 of a general safe operating area SOA over temperature and supply voltage for a vehicle control circuit in accordance with an exemplary embodiment. As shown in Figure 1, the safe operating area SOA has a rectangular shape in the temperature-voltage plane and is delimited by a minimum supply voltage Vₘᵢₙ (1.8 V in this example and also referred to as minimum safe operating voltage), a minimum temperature Tₘᵢₙ (-40°C in this example), a maximum supply voltage Vₘₐₓ (2.85 V in this example and also referred to as maximum safe operating voltage), and a maximum temperature Tₘₐₓ (175°C in this example).

The goal of the power management IC function is to guarantee that the digital block will operate only within this rectangular safe operating area SOA. This may involve a voltage monitor with an undervoltage monitor and an overvoltage monitor. It follows that the undervoltage monitor must have its lower limit set somewhat above the minimum supply voltage Vₘᵢₙ (1.8 V in this example). Similarly, the overvoltage monitor must have its upper limit lower set somewhat below the maximum supply voltage Vₘₐₓ (2.85 V in this example). To meet all these requirements, the power management sequencer needs to supply the digital block within a certain voltage range to avoid occurrence of wrong under or overvoltage monitoring.

One way of obtaining ASIL D compliance is (as mentioned in the introduction) to use redundancy, i.e. several undervoltage monitors and several overvoltage monitors to allow detection of latent faults in the monitoring functions. However, the present invention provides a different solution that is capable of reliably detecting a power supply voltage monitoring malfunction without the increased die size and additional power consumption of the redundancy-based solution.

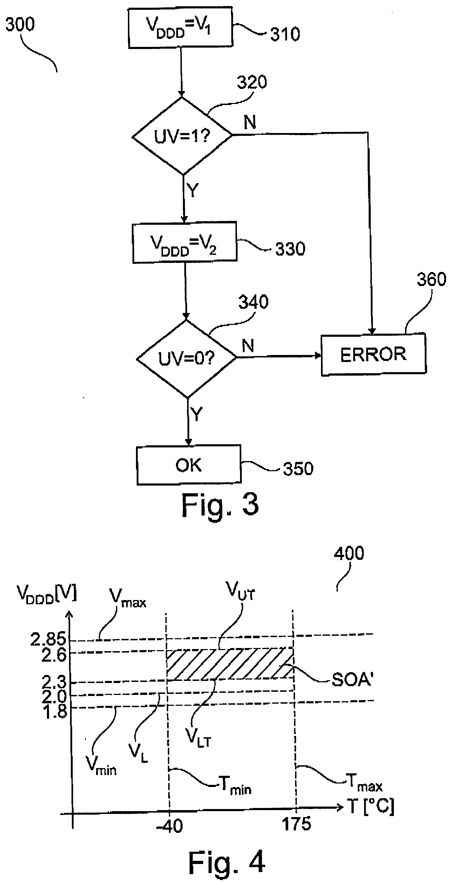

Figure 2 shows a diagram 200 of a system comprising a device for verifying the function of a power supply monitor in accordance with an exemplary embodiment. More specifically, the system 200 comprises a sleep mode digital block 210 (also referred to as controller 210), a supply voltage regulator 220, a supply voltage monitor 230, and an active mode digital block. The controller 210 is powered by voltage regulator 202 which supplies a voltage 204 to both the controller 210 and a supply monitor 206. The supply monitor 206 comprises an undervoltage monitor UV which provides an output signal 208 to the controller 210 such that the controller 210 is aware of whether its own power supply is working properly or not. The controller 210 generally handles the transition from a sleep mode to an active mode of the vehicle (not shown) and vice versa. In other words, when a user e.g. enters the vehicle and turns it on, the controller 210 takes care of the necessary initial processes, checks and controls in order to start the vehicle. If everything works fine, the control is then taken over by the active mode digital block 240 during driving. Hence, the active mode digital block 240 is, in contrast to the controller 210, safety relevant and its power supply voltage 222 must consequently be monitored by a reliable monitor in order to comply with ASIL D. This monitoring and its verification will be described in more detail below in conjunction with Figure 3. The controller 210 provides two control signals to the voltage regulator 220: a first control signal 212 (also referred to as "VDDD_enable") for activating the voltage regulator 220 and a second control signal 214 (also referred to as "VDDD=1.9V") for setting the supply voltage 222 to a certain value used in the verification of the supply voltage monitor 230. As shown, the supply voltage monitor 230 comprises a single undervoltage monitoring unit UV providing an output signal to both the active mode digital block 240 and the controller 210. Furthermore, the supply voltage monitor 230 comprises two (redundant) overvoltage monitoring units OV1, OV2 providing respective output signals 234, 236 to the active mode digital block 240. It should be noted that the redundant units OV1, OV2 may be replaced by a single OV unit in other exemplary embodiments.

Figure 3 shows a flowchart of a method 300 of verifying the function of a power supply monitor (such as the supply voltage monitor 230 shown in Figure 2 and discussed above) in a digital control system, wherein the power supply monitor is adapted to monitor whether or not a power supply voltage is between a lower threshold value and an upper threshold value, in accordance with an exemplary embodiment.

The method 300 begins at 310 where the supply voltage V_{DDD} 222 is to a first value V₁ which is below the lower threshold value. As will be further explained, the lower threshold value is a voltage value somewhat above the minimum operating voltage Vₘᵢₙ. Referring back to Figure 2, setting the supply voltage 222 to the first value V₁ may be done by setting the control signals 212 and 214 correspondingly.

Then, at 320, a first check is performed by checking that the power supply monitor 230, more specifically the signal 232 from the undervoltage monitor UV in Figure 2, indicates that the supply voltage 222 is below the lower threshold value, i.e. it is checked whether the signal 232 indicates UV=1 (undervoltage) or UV=0 (no undervoltage). If the signal 232 indicates an undervoltage, then the method continues to 330. Otherwise, the method continues to 360 where an error is noted.

At 330, the supply voltage V_{DDD} 222 is set to a second value V₂ which is within the safe operating range between the lower threshold value and the upper threshold value. In particular, the second value V₂ may correspond to the supply voltage desired for operation.

Then, at 340, a second check is performed by checking that the power supply monitor 230, more specifically the signal 232 from the undervoltage monitor UV in Figure 2, now changes to indicate that the supply voltage 222 is above the lower threshold value, i.e. it is checked whether the signal 232 indicates UV=0 (no undervoltage) or UV=1 (undervoltage). If the signal 232 does not indicate an undervoltage, then the method continues to 350 where the function of the power supply monitor 230 is verified. Otherwise, the method continues to 360 where an error is noted. Here, at 360, after noting an error several actions may be taken depending on the circumstances. In some cases, the verification method 300 may be repeated. In other cases, the active mode digital block may be reset and/or an error message may be output.

Figure 4 shows an illustration 400 of a power supply operating area SOA' for a vehicle control circuit that may advantageously be used in accordance with an exemplary embodiment, including the embodiment discussed above. Figure 4 is similar to Figure 1 but includes some additional voltage levels and a somewhat smaller operating area SOA' in comparison to SOA in Figure 1. The purpose of the smaller operating area SOA' is to take the voltage regulator accuracy of around +/-5% into account in order to assure correct monitor verification. The voltage levels Vₘᵢₙ and Vₘₐₓ are the same as in Figure 1, i.e. the theoretical minimum and maximum values of the supply voltage between which the circuit 240 may operate correctly. The voltage level V_{L} (V_{L}=2.0 V in this example) delimits a small range above Vₘᵢₙ in which the first value V₁ discussed above can be set, e.g. to V₁=1.9 V such that it can be assumed that the regulator accuracy will keep it between Vₘᵢₙ and V_{L}. The voltage level V_{LT} (V_{LT}=2.3 V in this example) defines, together with V_{L}, a corresponding range for the lower threshold value. Hence, given the regulator accuracy of +/-5% and setting the lower threshold value to a value around the middle of this range, e.g. to 1.15 V, it can be assured that the undervoltage monitor will not toggle (or change its output value) for an actual voltage above 2.3 V. Finally, the voltage level V_{UT} (V_{UT}=2.6 V in this example) defines, together with Vₘₐₓ, a range for the upper threshold value. That is, by setting the upper threshold value to a value around the middle of this range, e.g. to 2.73 V, it can be assured that an overvoltage is not detected as long as the actual voltage is below 2.6 V.

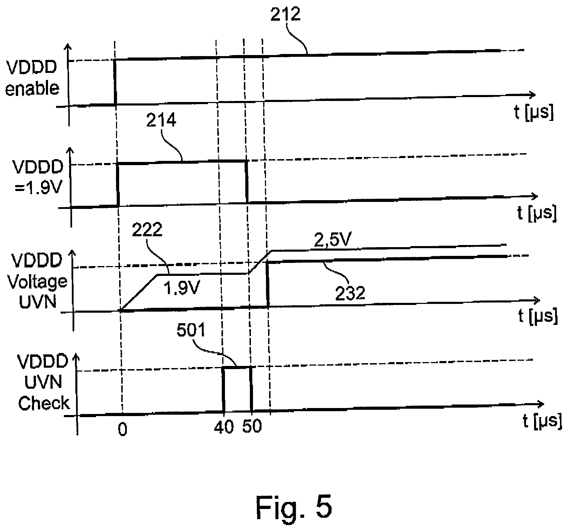

Figure 5 shows voltages and control signals as functions of time during a successful verification of the function of the power supply monitor 230 in accordance with an exemplary embodiment. As shown, at t=0, the voltage regulator 220 is activated by switching the control signal 212 to high and set to supply a voltage 222 of 1.9 V (first value V₁) by also switching the control signal 214 to high. This causes the voltage regulator 220 to ramp the voltage 222 up to 1.9 V while the negated output signal 232 UVN from the undervoltage monitor UV remains low, thus indicating that the voltage 222 is below the lower threshold value. As indicated by the pulse 501 between t=40 µs and t=50 µs, it is checked whether the undervoltage monitor value UVN is correct. Since this is the case, the control signal 214 is switched to low while the control signal 212 is maintained high such that the regulator 220 will now switch to normal supply voltage, i.e. a supply voltage 222 of 2.5 V (second value V₂). This causes the supply voltage 222 to ramp up further and once it crosses the lower threshold value, the undervoltage monitor signal UVN goes high after less than 10 µs, correctly indicating that no undervoltage situation is present. Thus, it has been verified that the undervoltage monitor UV in the supply voltage monitor 230 works correctly.

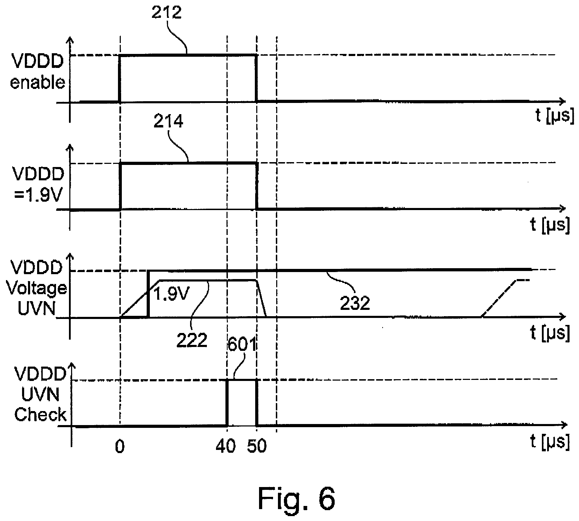

Figure 6 shows voltages and control signals as functions of time during a non-successful verification of the function of the power supply monitor 230 in accordance with an exemplary embodiment. Like in Figure 5, the voltage regulator 220 is activated at t=0 by switching the control signal 212 to high and set to supply a voltage 222 of 1.9 V (first value V₁) by also switching the control signal 214 to high. This causes the voltage regulator 220 to ramp the voltage 222 up to 1.9 V. In this case, contrary to Figure 5, the negated output signal 232 UVN from the undervoltage monitor UV switches from low to high, thus indicating that the voltage 222 is below the lower threshold value, already before the voltage 222 reaches the target 1.9 V. As indicated by the pulse 601 between t=40 µs and t=50 µs, it is checked whether the undervoltage monitor value UVN is correct. Since this is not the case, both control signals 214 and 212 are switched to low such that the regulator 220 is deactivated. This causes the supply voltage 222 to ramp back down to 0 V. Thus, in this case it could not be verified that the undervoltage monitor UV in the supply voltage monitor 230 works correctly. In this case, the system may wait for a while and then perform another attempt to verify the undervoltage monitor, or it may issue an error notification indicating that a repair is necessary.

Thanks to this solution which combines a programmable VDDD output voltage regulator 220 and an Active mode digital block UV monitor having its output connected to the sleep mode digital block 210, any failure of the UVN monitor can be detected and registered. Moreover, the active mode digital block 240 will be unpowered in case of failure, which is a safe state. Thus, an effective way of assuring ASIL D compliance without space and power consuming redundancy has been obtained.

It should be noted that although the specific examples shown in the Figures and discussed above only verifies the function of the undervoltage monitoring unit UV of the power supply monitor 230, the redundant overvoltage monitoring units OV1, OV2 shown in Figure 2 may also be replaced by a single overvoltage monitoring unit in a similar manner, provided that the operating voltage range is wide enough which is not the case in the above examples. The single overvoltage monitoring unit might then be verified by programming the regulator to supply a voltage above the upper threshold value (third value) and thereafter a voltage below the upper threshold value (fourth value). If the overvoltage monitoring unit delivers a correct output signal in both situations, its function has been verified.

It is noted that, unless otherwise indicated, the use of terms such as "upper", "lower", "left", and "right" refers solely to the orientation of the corresponding drawing.

It is noted that the term "comprising" does not exclude other elements or steps and that the use of the articles "a" or "an" does not exclude a plurality. Also elements described in association with different embodiments may be combined. It should also be noted that reference signs in the claims should not be construed as limiting the scope of the claims.

## Claims

1. A method of verifying a function of a power supply monitor (230) in a digital control system, wherein the power supply monitor is adapted to monitor whether or not a power supply voltage (VDDD) is between a lower threshold value (V_{LT}) and an upper threshold value (V_{UT}), the method comprising
setting (310) the power supply voltage to a first value (V₁), the first value being below the lower threshold value,
checking (320), as a first check, that the power supply monitor indicates that the power supply voltage is below the lower threshold value,
setting (330) the power supply voltage to a second value (V₂), the second value being above the lower threshold value and below the upper threshold value,
checking (340), as a second check, that the power supply monitor indicates that the power supply voltage is above the lower threshold value, and
verifying (350) the function of the power supply monitor if both the first check and the second check are successful.

2. The method according to claim 1, further comprising
resetting (360) the digital control system and/or issuing an error message if at least one of the first check and the second check is not successful.

3. The method according to claim 1 or 2, wherein the first value is larger than a minimum safe operating voltage (Vₘᵢₙ) of the digital control system.

4. The method according to any of claims 1 to 3, wherein the first value is 1.9 V and/or wherein the second value is 2.5 V, and/or wherein the lower threshold value is 2.0 V and/or wherein the upper threshold value is 2.6 V.

5. The method according to any of claims 1 to 4, further comprising
setting the power supply voltage to a third value, the third value being above the upper threshold value,
checking, as a third check, that the power supply monitor indicates that the power supply voltage is above the upper threshold value,
setting the power supply voltage to a fourth value, the fourth value being below the upper threshold value and above the lower threshold value, and
checking, as a fourth check, that the power supply monitor changes to indicate that the power supply voltage is below the upper threshold value,
wherein the function of the power supply monitor is verified if, in addition to the first check and the second check, also the third check and the fourth check are successful.

6. The method according to claim 5, further comprising
resetting the digital control system and/or issuing an error message if at least one of the first check, the second check, the third check, and the fourth check is not successful.

7. The method according to claim 5 or 6, wherein the third value is less than a maximum safe operating voltage (Vₘₐₓ) of the digital control system.

8. A device for verifying a function of a power supply monitor (230) in a digital control system, wherein the power supply monitor is adapted to monitor whether or not a power supply voltage (VDDD) is between a lower threshold value (V_{LT}) and an upper threshold value (V_{UT}), the device comprising
a controller (210) in communication with a power supply voltage regulator (220) and the power supply monitor, wherein the controller is configured to:
send a first control signal to the power supply voltage regulator to set the power supply voltage to a first value (V₁), the first value being below the lower threshold value,
check, as a first check, that a first feedback signal received from the power supply monitor indicates that the power supply voltage is below the lower threshold value,
send a second control signal to the power supply voltage regulator to set the power supply voltage to a second value (V₂), the second value being above the lower threshold value and below the upper threshold value,
check, as a second check, that a second feedback signal received from the power supply monitor indicates that the power supply voltage is above the lower threshold value, and
verify the function of the power supply monitor if both the first check and the second check arc successful.

9. The device according to claim 8, wherein the controller is further configured to reset the digital control system and/or issue an error message if at least one of the first check and the second check is not successful.

10. The device according to claim 8 or 9, further comprising at least one of the following features:
wherein the first value is 1.9 V,
wherein the second value is 2.5 V,
wherein the lower threshold value is 2.0 V, and
wherein the upper threshold value is 2.6 V.

11. The device according to any of claims 8 to 10, wherein the controller is further configured to:
send a third control signal to the power supply voltage regulator to set the power supply voltage to a third value, the third value being above the upper threshold value,
check, as a third check, that a third feedback signal received from the power supply monitor indicates that the power supply voltage is above the upper threshold value,
send a fourth control signal to the power supply voltage regulator to set the power supply voltage to a fourth value, the fourth value being below the upper threshold value and above the lower threshold value, and
check, as a fourth check, that a fourth feedback signal received from the power supply monitor indicates that the power supply voltage is below the upper threshold value,
wherein the function of the power supply monitor is verified if, in addition to the first check and the second check, also the third check and the fourth check are successful.

12. The device according to claim 11, wherein the controller is further configured to reset the digital control system and/or issue an error message if at least one of the first check, the second check, the third check, and the fourth check is not successful.

13. The device according to any of claims 8 to 12, wherein the digital control system is ASIL D compliant.

14. The device according to any of claims 8 to 13, wherein the power supply monitor comprises
an undervoltage monitoring unit (U V) configured to compare the power supply voltage with the lower threshold value and to output a signal indicative of whether the power supply voltage is below or above the lower threshold value, and
at least one overvoltage monitoring unit (OV1, OV2) configured to comparc the power supply voltage with the upper threshold value and to output a signal indicative of whether the power supply voltage is below or above the upper threshold value.

15. A computer program comprising computer executable instructions which, when executed by a computer, causes the computer to perform a method of verifying a function of a power supply monitor in a digital control system, wherein the power supply monitor is adapted to monitor whether or not a power supply voltage is between a lower threshold value and an upper threshold value, the method comprising
setting the power supply voltage to a first value, the first value being below the lower threshold value,
checking, as a first check, that the power supply monitor indicates that the power supply voltage is below the lower threshold value,
setting the power supply voltage to a second value, the second value being above the lower threshold value and below the upper threshold value,
checking, as a second check, that the power supply monitor indicates that the power supply voltage is above the lower threshold value, and
verifying the function of the power supply monitor if both the first check and the second check are successful.
